# EUROPEAN PATENT APPLICATION

(11) **EP 0 773 614 A1**
(43) Date of publication of application: **14.05.1997**
(21) Application number: 96118024.7
(22) Date of filing: 11.11.1996
(51) Int. Cl.: H01S 3/085

(54) **Low resistance P-down top emitting ridge VCSEL and method of fabrication**

(30) Priority: 13.11.1995 US 558072
(71) Applicant: MOTOROLA, INC., Schaumburg, IL 60196 (US)
(72) Inventor: Lebby, Michael S., Apache Junction, Arizona 85219 (US); Sheih, Chan-Long, Paradise Valley, Arizona 85253 (US); Claisse, Paul, Tempe, Arizona 85283 (US)
(74) Representative: Hudson, Peter David

(57) **Abstract**

A high efficiency vertical cavity surface emitting laser (30) including first (31) and second (37) mirror stacks with an active region (32) sandwiched therebetween having an optical mode. The second mirror stack (37) is formed into a mesa with exposed end surface and having outer sidewalls and a diametric size greater than the optical mode. A portion (38) of the first mirror stack (31) adjacent the active region (32) has a reduced electrical conductance so as to channel operating current from the first mirror stack (31) into the optical mode of the active region (32).

The device is grown on a p-type substrate.

## Description

### BACKGROUND OF THE INVENTION

### Field of the Invention

This invention relates to vertical cavity surface emitting lasers and more specifically to vertical cavity surface emitting lasers with a mesa structure and a light emission window on the surface of the mesa.

### Prior Art

Vertical cavity surface emitting lasers are well known, and are formed in a wide variety of configurations. However, the basis for the laser in virtually all configurations is an active area sandwiched between two mirror stacks. The laser is activated by driving an electrical current through the two mirror stacks and the active area. This is generally accomplished by placing a first electrode across the mirror stack at one end of the laser and a second electrode across the other mirror stack at the other end of the laser. One of the electrodes generally defines a central opening therethrough for the emission of light. Traditionally, and for convenience in manufacturing, VCSEL devices are fabricated with P-type conductivity material forming the top mirror stack and N-type conductivity material forming the bottom mirror stack, generally carried by an N-type conductivity substrate.

For maximum efficiency and in order to sustain a single lateral mode, it is necessary that the major portion of the current be injected into the active region in the optical mode or lasing area. Current outside the lasing area is generally wasted or produces lasing which is wasted.

To overcome this problem, many devices employ a mesa, through which the current is injected, having a size closely corresponding to the optical mode. While this reduces wasted current or lasing, it results in an increase in series resistance, reducing efficiency. Further increasing series resistance is the necessary reduction in the area of the top electrode. While the size of the mesa is reduced, the emission window remains the same, causing the reduction in the area of the electrode.

In order to drive the vertical cavity surface emitting laser with a conventional current source laser driver to multi-GHz operation, the series resistance of the device must be reduced. The specific contact resistance of the top mirror stack and the top electrode depends on the doping concentration. However, the doping concentration is constrained by the need to minimize the optical loss due to free carriers. Therefore, optimized doping alone can not achieve a series resistance low enough for multi-GHz operation.

Series resistance can be greatly reduced by increasing the size of the mesa, specifically the top mirror stack, as disclosed in a co-pending U.S. patent application entitled "Low Resistance Top Emitting Ridge VCSEL and Method of Fabrication", attorney docket number CR95-017, assigned to the same assignee. The current is controlled to enter the active region in an optical mode by oxidized or undercut portions of the top mirror stack adjacent the active region. While effectively reducing series resistance, a further reduction is desirable.

It would be highly advantageous, therefore, to remedy the foregoing and other deficiencies inherent in the prior art.

Accordingly, it is an object of the present invention to provide improvements in vertical cavity surface emitting lasers.

Another object of the invention is to provide a vertical cavity surface emitting laser with a current path closely coordinated with the optical mode.

And another object of the invention is to provide a vertical cavity surface emitting laser with a current path closely coordinated with the optical mode and having reduced series resistance.

### SUMMARY OF THE INVENTION

Briefly, to achieve the desired objects of the instant invention in accordance with a preferred embodiment thereof, provided is a high efficiency vertical cavity surface emitting laser including a substrate, a first mirror stack having p-type conductivity positioned on the substrate, an active region positioned on the first mirror stack, a second mirror stack having n-type conductivity positioned on the active region, and a portion of the first mirror stack adjacent the active region having a reduced electrical conductance so as to channel operating current from the first mirror stack into an optical mode of the active region.

### BRIEF DESCRIPTION OF THE DRAWINGS

The foregoing and further and more specific objects and advantages of the instant invention will become readily apparent to those skilled in the art from the following detailed description of a preferred embodiment thereof taken in conjunction with the drawings, in which:
FIG. 1 is a partial sectional view of a conventional vertical cavity surface emitting laser;
FIG. 2 is a sectional view of a vertical cavity surface emitting laser as it would appear in an intermediate stage of fabrication;
FIG. 3 is a sectional view of a vertical cavity surface emitting laser constructed in accordance with the teachings of the present invention; and
FIG. 4 is a sectional view of a slightly different embodiment of a vertical cavity surface emitting laser constructed in accordance with the teachings of the present invention.

### DETAILED DESCRIPTION OF THE PREFERRED EMBODIMENTS

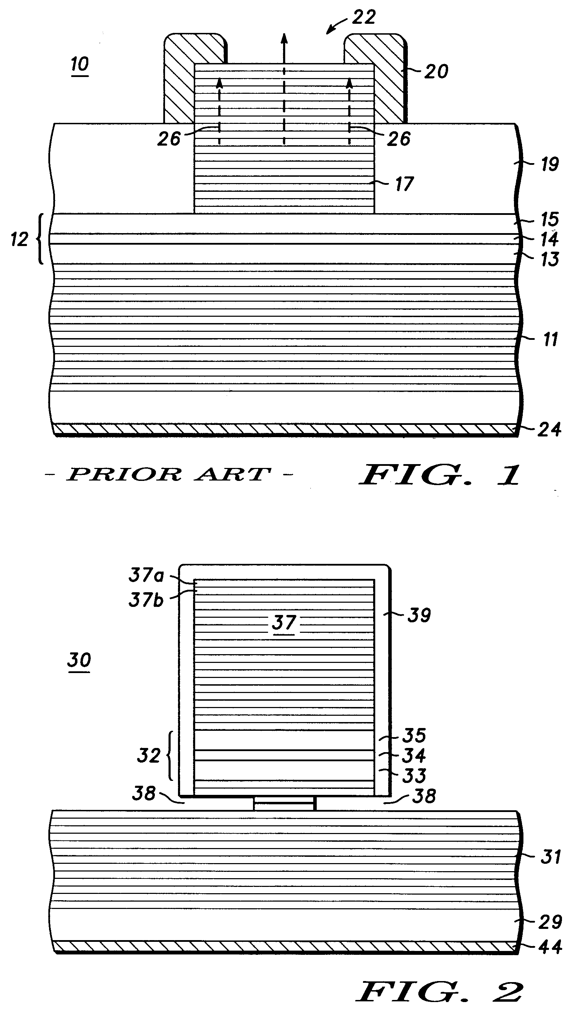

Turning now to the drawings in which like reference characters indicate corresponding elements throughout the several views, attention is first directed to Fig. 1 which illustrates a vertical cavity surface emitting laser (VCSEL) generally designated 10. VCSEL 10 includes a first mirror stack 11 formed of N-type conductivity material, an active region 12 having a first cladding layer 13, an active layer 14 (such as quantum wells and the like) and a second cladding layer 15, and a second mirror stack 17 formed of P-type conductivity material. Second mirror stack 17 is etched, or selectively deposited, to form a mesa-like structure. An electrical contact 20 is formed in contact with at least the upper end of second mirror stack 17. Electrical contact 20 defines a window 22 for the emission of light from VCSEL 10 through second mirror stack 17. A second electrical contact 24 is positioned over the lower surface of first mirror stack 11. This VCSEL is referred to as having a P-up configuration.

An operating voltage applied across contacts 20 and 24 produces a current flow through VCSEL 10 which produces the lasing action as is well known. In general, because of the position of electrical contact 20 on the surface of second mirror stack 17, current flows throughout the mesa-like structure of second mirror stack 17 and lasing is supported wherever current flows. Since current outside the optical mode is wasted and may even interfere with proper operation of the VCSEL, typically, the diametric size of the mesa is dependent upon the required optical mode output of the VCSEL, with the diameter closely matching the optical mode. In this manner, current flow is generally limited to the region of the optical mode.

The problem is that series resistance, resulting in part from the reduced size of second mirror stack 17, is too high to operate VCSEL 10 in multi-Ghz bandwidth. Conventionally, in order to sustain a single lateral mode, the size of the mesa is approximately 10 microns. Further increasing resistance is the reduced area of contact 20 resulting from the inclusion of emission window 22. These factors limit the series resistance of a VCSEL having a 10 micron mesa to approximately 100 Ohms. In order to drive the VCSEL with a conventional current source laser driver to multi-Ghz operation, the series resistance must be reduced further.

It has been found that the holes present in P-type conductivity material move more slowly than the electrons present in the N-type conductivity material. Thus, the inherent resistance of the P-type conductivity material is higher than the resistance of the N-type conductivity. In conventional VCSELs employing a mesa, the top mirror stack is formed of P-type conductivity material. The top mirror stack has high resistance because of the reduction in area due to the formation of the mesa-like structure and because it is formed of a material which is already more resistive than if it were formed from N-type conductivity material. Therefore, to reduce series resistance, it has been determined that the portion of the VCSEL having a reduced area, namely the mesa-like structure, should be formed from N-type conductivity material.

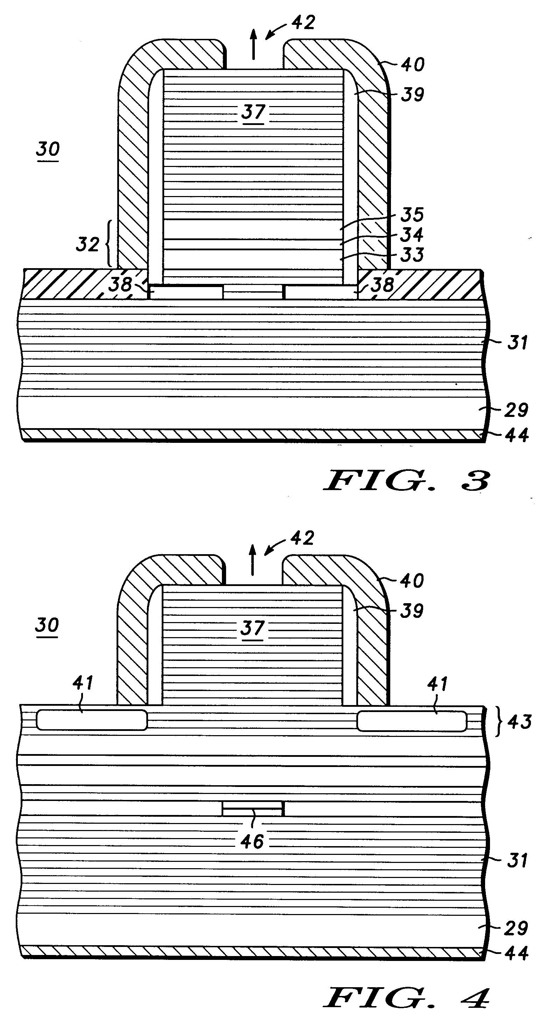

Referring to FIG. 2, a vertical cavity surface emitting laser 30 (VCSEL) embodying the present invention is illustrated. VCSEL 30 is formed on a substrate 29 in a P-down configuration. VCSEL 30 includes a first mirror stack 31 (positioned on substrate 29), formed of a P-type conductivity material, an active region 32 having a first cladding layer 33, an active layer 34 and a second cladding layer 35, and a second mirror stack 37 formed of a N-type conductivity material. Second mirror stack 37 is etched, or selectively deposited, to form a mesa-like structure, as described above. However, in the present invention, the series resistance of VCSEL 30 is lowered by increasing the diametric size of second mirror stack 37 which permits spreading of the current flow.

To further reduce series resistance, first mirror stack 31 is formed with P-type conductivity material, while second mirror stack 37 is formed with N-type conductivity material. This further reduces resistance because N-type conductivity material has a lower resistance than does P-type conductivity material. Thus, in comparison with the traditional P-up configuration, the P-down configuration provides the higher resistance P-type conductivity material of first mirror stack 31 with a large area. The large area permits spreading of the current flow, thus reducing resistance. The N-type conductivity material of second mirror stack 37 is inherently less resistive, and thus the reduction of the area of second mirror stack 37, formed of N-type conductivity material, to form the mesa will be less significant than if it were conventionally formed of P-type conductivity material.

Increasing the diametric size of the mesa-like structure and forming second mirror stack 37 of N-type conductivity material greatly reduces resistance, but also allows current flow into active region 32 outside the optical mode. To control the current flow into active region 32, the electrical conductance of a portion 38 of first mirror stack 31 adjacent active region 32 is reduced.

Portion 38 includes the outer circumference of one or more mirror pairs of first mirror stack 31 adjacent active region 32. This is preferably accomplished by etching second mirror stack 37 to form the mesa like structure, and etching through active layer 32 to first mirror stack 31. Generally, etching active region 32 will cause defects which greatly reduce the lifetime of the VCSEL, or render it completely inoperable. However, due to the increased diametric size of the mesa-like structure, the etched portion of active region 32 is laterally removed from the operative portion of active region 32. The operative portion being within the optical mode or lasing area. Being removed from the optical mode or lasing area, defects generated by the etch will not effect the active region 32 at the optical mode.

First stack of mirrors 37 is formed predominantly of alternating low and high aluminum containing layers 37a and 37b of AlGaAs distributed Bragg reflectors. Alternating layer 37a and 37b provide alternating high and low indexes of refraction. After active layer 32 has been etched, a dielectric layer 39 is deposited and etched back, covering the sides and top of the mesa-like structure and active region 32, leaving the first layer of first mirror stack 31 exposed. The first pair of layers or a few pairs of layers of first mirror stack 31 are then etched. This exposes an outer edge of the first pair of layers. In this specific embodiment, alternating layers 37a and 37b of low and high aluminum containing AlGaAs adjacent active region 32 are selectively oxidized in accordance with the aluminum content. The layer of the mirror pair having a high concentration of aluminum is readily oxidized, reducing its electrical conductance. The oxidation in this embodiment is accomplished by subjecting the outer edges of the first mirror layers to a nitrogen ambient containing water moisture. In this ambient the natural oxidation of the aluminum produces high resistance portion 38 within the mirror pairs adjacent active region 32. Alternatively, portion 38 of the mirror pairs may be removed by etching. Selective wet etching is performed by using diluted HF or diluted HCL. Active region 32 and second mirror stack 37 are protected from the etch or oxidation by dielectric layer 39. Only one or a few mirror pairs adjacent active region 32 is susceptible to the etch or oxidation. The optical mode and threshold current can be controlled by the degree of undercut or oxidation without adverse impact on the series resistance.

The low electrical conductance of portion 38 also helps enhance the reliability and lifetime of VCSEL 10 by allowing the undoped first cladding layer 33 to be fully depleted, reducing migration of both defects and carriers into active layer 34 and causing degradation. Use of implants 41 as illustrated in FIG. 4, also aids in preventing migration of defects and carriers. In order to include implants, a lower portion 43 of second mirror stack 37 and active region 32 are etched to provide them with a larger diametric size than the mesa-like structure, to provide room for implants 41.

In addition to the depletion of carriers in undoped first cladding layer 33 and the optional incorporation of implants 41, a layer of an indium based alloy (e.g. InAlGaP, InAs, etc.), designated 46, can be optionally included in the opening defined by portion 38. All of the operating current flowing in VCSEL 30 flows through the opening defined by portion 38 and, thus, any defects carried by the current must pass through the opening. It has been found that a layer of an indium based alloy substantially prevents defects from passing therethrough. Thus, in applications which justify the additional steps of forming a layer of indium based alloy in or between mirror pairs making up the portion 38 and the opening defined thereby, this feature produces additional reduction in defects migrating to the active area and, therefore, further increases the life of VCSEL 30.

The size of portion 38 which is removed or oxidized depends on the overall diametric size of the mesa, and the desired operating mode. Preferably, portion 38 is the diameter of the mirror pairs outside the desired optical mode. Thus, the reduced electrical conductance of portion 38 results in a funneling of the current into active region 32 at the optical mode. Current travels the shortest distance, path of least resistance, between two points. Therefore, current will pass through active region 32 only in the optical mode as controlled by portion 38. To achieve a lower resistance, the diametric size of the mesa is greater than one times larger than the optical mode of the VCSEL. In the preferred embodiment, the diametric size of the mesa is at least twice as large as the operating mode.

An electrical contact 40 is formed in contact with at least the upper end of second mirror stack 37. Electrical contact 40 defines a window 42 for the emission of light from VCSEL 30 through second mirror stack 37. A second electrical contact 44 is positioned over the lower surface of first mirror stack 31. The area of electrical contact 40 is increased proportional to the increase in the diametric size of the mesa-like structure. Since window 44 for the emission of light stays the same, corresponding to the optical mode, the larger the diametric size of the mesa-like structure, the larger the area of contact. This gives a much greater area for contact without shadowing the emitting light, thereby reducing series resistance due to ohmic contact.

Thus, current injection is controlled, with current injected into active region 32 in the optical mode, and series resistance is greatly reduced due to the large diametric size of second mirror stack 37, the correspondingly large area of contact, and by using a p-down structure which presents the top mirror stack, formed into a mesa, as N-type conductivity material. The N-type conductivity material has less resistance than P-type conductivity material.

Various changes and modifications to the embodiments herein chosen for purposes of illustration will readily occur to those skilled in the art. To the extent that such modifications and variations do not depart from the spirit of the invention, they are intended to be included within the scope thereof which is assessed only by a fair interpretation of the following claims.

Having fully described the invention in such clear and concise terms as to enable those skilled in the art to understand and practice the same, the invention claimed is:

## Claims

1. A high efficiency vertical cavity surface emitting laser (30) comprising:
a substrate (29);
a first mirror stack (31) having p-type conductivity positioned on the substrate (29);
an active region (32) positioned on the first mirror stack (31);
a second mirror stack (37) having n-type conductivity positioned on the active region (32); and
a portion (38) of the first mirror stack (31) adjacent the active region (32) having a reduced electrical conductance so as to channel operating current from the second mirror stack (37) into an optical mode of the active region (32).

2. A high efficiency vertical cavity surface emitting laser as claimed in claim 1 wherein said second mirror stack (37) is formed as a mesa with an exposed end surface, outer sidewalls and a diametric size greater than one times larger than the optical mode.

3. A high efficiency vertical cavity surface emitting laser as claimed in claim 2 wherein the portion (38) of the first mirror stack (31) adjacent the active region (32) includes an outer periphery of one layer of a mirror pair adjacent the active region (32).

4. A high efficiency vertical cavity surface emitting laser as claimed in claim 3 wherein the first mirror stack (31) includes alternating layers of high and low aluminum content AlGaAs forming mirror pairs and the portion (38) with reduced electrical conductance includes an outer periphery of the high aluminum content AlGaAs layer of the mirror pair adjacent the active region (42).

5. A high efficiency vertical cavity surface emitting laser as claimed in claim 4 wherein the portion (38) with reduced electrical conductance includes an oxidized outer periphery of the high aluminum content AlGaAs layer adjacent the active region (32).

6. A high efficiency vertical cavity surface emitting laser as claimed in claim 4 wherein the portion (38) with reduced electrical conductance includes a removed outer periphery of the high aluminum content AlGaAs layer adjacent the active region (32).

7. A high efficiency vertical cavity surface emitting laser as claimed in claim 2 wherein the diametric size of the mesa is at least twice as large as the optical mode.

8. A high efficiency vertical cavity surface emitting laser as claimed in claim 1 including in addition a layer (46) of indium based alloy positioned in the optical mode of the active region (32).

9. A method of fabricating a high efficiency vertical cavity surface emitting laser (30) comprising the steps of:
providing a substrate (29);
forming a first mirror stack (31) having p-type conductivity on the substrate (29);
forming an active region (32) on the first mirror stack (31);
forming a second mirror stack (37) having n-type conductivity on the active region (32); and
reducing the electrical conductance of a portion (38) of the first mirror stack (31) adjacent the active region (32) to channel operating current from the first mirror stack (31) into an optical mode of the active region (32).

10. A method of fabricating a high efficiency vertical cavity surface emitting laser as claimed in claim 9 wherein the step of forming the first mirror stack (31) includes depositing alternating layers of high and low aluminum content AlGaAs forming mirror pairs and the step of reducing the electrical conductivity further includes oxidizing the outer periphery of the high aluminum content AlGaAs layer adjacent the active region (32).
